# EUROPEAN PATENT APPLICATION

(11) **EP 4 272 974 A1**
(43) Date of publication of application: **08.11.2023**
(21) Application number: 23171484.1
(22) Date of filing: 04.05.2023
(51) Int. Cl.: B44C 1/22, B44C 3/00, B60B 7/00

(54) **METHOD OF MANUFACTURING MULTI-COLOR VEHICLE WHEEL USING LASER ABLATION**

(30) Priority: 04.05.2022 US 202263338151 P
(71) Applicant: Superior Industries International, Inc., Southfield, MI 48033 (US)
(72) Inventor: SCHWING, Thomas, Hickory Creek, TX, 75065 (US); CHENAULT III, Henry Clay, Fayetteville, AR, 72704 (US); WATTS, Christopher Allen, Milford, MI, 48381 (US)
(74) Representative: Bardehle Pagenberg Partnerschaft mbB Patentanwälte Rechtsanwälte

(57) **Abstract**

A vehicle wheel and method of manufacturing the vehicle wheel is disclosed. A first polymeric coating (18) is applied to a surface (14) of an alloy substrate (12) that defines the vehicle wheel. The first polymeric coating defines a first coloration. An intermediate clear polymeric coating (20) is applied over the first polymeric coating. A second polymeric coating (22) is applied over the first polymeric coating with the second polymeric coating defining a second coloration that is distinguishable from the first coloration. A laser scans a pattern over the second polymeric coating resulting in ablation of the second polymeric coating rendering the first polymeric coating visible through the intermediate clear polymeric coating defining a pattern of exposed first polymeric coating. Thus, a two-tone appearance is present between the first coloration and the second coloration in the shape of the pattern scanned by the laser.

## Description

### PRIOR APPLICATIONS

The present application claims priority to United States Provisional Patent Application No. 63/338,151 filed on May 4, 2022, the contents of which are incorporated herein by reference.

### TECHNICAL FIELD

The present invention relates generally toward a method of coating a vehicle wheel providing a multi-color appearance. More specifically, the present invention relates toward a method of coating a vehicle wheel with polymeric coatings and using laser ablation to selectively remove areas of polymer coatings to achieve a unique, multi-color appearance.

### BACKGROUND

Vehicle wheel manufacturers have been seeking to improve wheel aesthetics providing unique distinguishing features to meet ever increasing consumer desires. One such example is a desire for a vehicle wheel having multiple colors providing a two-tone or multi-color appearance. However, achieving a multi color or two-tone appearance has not proven particularly suitable for mass production. One such problem is the inability to apply a paint mask over an existing coating prior to application of a second coating having a different color due to a propensity of the mask to cause paint defects such as, for example, paint sags, paint contamination, and the like.

Efforts have been made to make use of alternative processes, some of which include laser ablation. However, laser ablation has not proven feasible for mass production wheels due to the damage heat associated with the laser causes colored coatings applied prior to the ablation step. In fact, laser ablation of a color coating has only been proven feasible when the laser is used to remove an entire portion of a coating exposing a vehicle wheel substrate that has been etched by the laser.

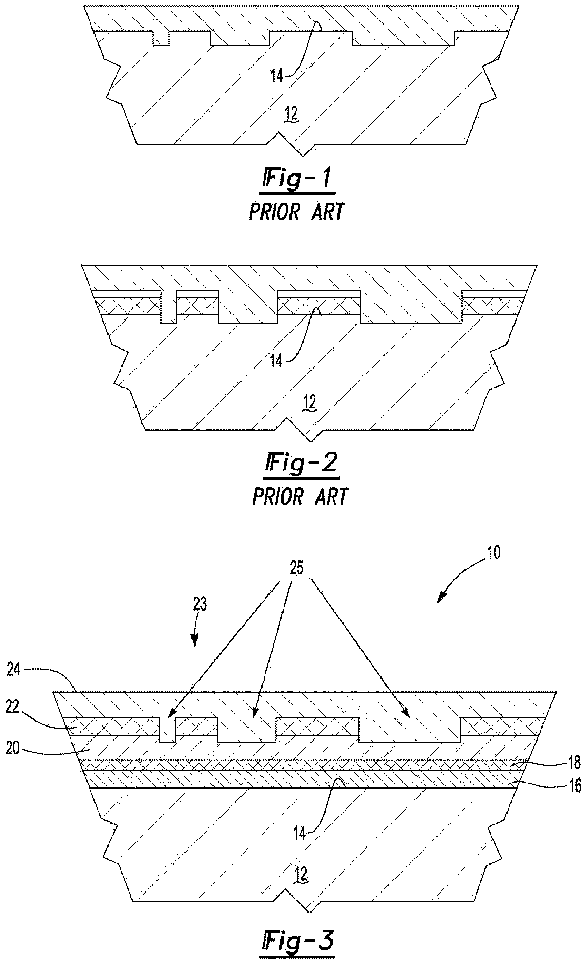

This process is shown in Figure 1 and Figure 2. Figure 1 shows a partial cross section of an alloy wheel substrate that received optical burning via a laser ablation prior to application of a polymer coating. The laser ablation results in an etch of the exposed alloy presenting a different appearance to that portion of the alloy that has not been subject to laser ablation. A clear polymer coating is applied to the wheel after laser ablation in a known manner resulting in two different shades of the exposed alloy, etched by way of laser ablation and milled and or cast. This process does not result in a two tone appearance, but only slight differences in the shade of the alloy.

Efforts have also been made to achieve more contrast between that portion of the vehicle wheel that has been etched by way of laser ablation presenting a more distinct two-tone appearance. Referring to Figure 2, a primer coating has been applied to the wheel substrate followed by a base color coating being applied over the primer coating. After curing the primer coating and base color coating, the two coatings are subject to laser ablation thereby removing all of both coatings and exposing a now etched alloy wheel substrate. While this process provides more contrast than the earlier disclosed process, achieving a desirable two-tone or multi-color appearance is still not achieved. Heat associated with laser ablation of polymer coatings is known to damage adjacent areas of the coating that has not been ablated by the laser. Therefore, laser ablation, when used during manufacturing of a vehicle wheel has been limited to etching an alloy wheel substrate. Therefore, it would be desirable to provide a process making use of the benefits of laser ablation while also achieving desired contrast between that portion of a polymer coating that has been subject to laser ablation and that which has not by ablating applied paint or layers of applied paint.

### SUMMARY

A vehicle wheel and method of manufacturing the vehicle wheel is disclosed. A first polymeric coating is applied to a surface of an alloy substrate that defines the vehicle wheel. The first polymeric coating defines a first coloration. An intermediate clear polymeric coating is applied over the first polymeric coating. A second polymeric coating is applied over the first polymeric coating with the second polymeric coating defining a second coloration that is distinguishable from the first coloration. A laser scans a pattern over the second polymeric coating resulting in ablation of the second polymeric coating rendering the first polymeric coating visible through the intermediate clear polymeric coating defining a pattern of exposed first polymeric coating. Thus, a two-tone appears is present between the first coloration and the second coloration in the shape of the pattern scanned by the laser.

For the first time, laser ablation is used to remove one polymer exposing another polymer coating previously applied. When the two polymer coatings have been provided with distinctive coloration, a unique two tone appearance is now achievable using laser ablation. In addition, a unique pattern is achievable presenting two different colors. The problem associated with damaged caused to a polymer coating by the heat associated with laser ablation is solved through the application of the clear polymer coating over the first color coating that has been a previously applied to a polymer primer. Still further, the intermediate clear polymeric coating includes a film thickness that is greater than a film thickness of the second polymeric coating being ablated by the laser. A partial ablation of the intermediate polymeric coating by the laser is not problematic to the overall appearance and durability of the vehicle wheel reducing a potential for defect caused by excessive ablation. In this manner, the laser removes the second polymeric coating and a portion of the intermediate polymeric coating exposing the first polymeric coating or primer that includes a different coloration than that of the second color coating without causing damage to the first polymeric coating.

### BRIEF DESCRIPTION OF THE DRAWINGS

Other advantages of the present invention will be really appreciated as the same becomes better understood by reference to the following detailed description when considered in connection with the accompanied drawings, wherein:
Figure 1 shows a cross-section of prior art wheel substrate that is etched using a laser;
Figure 2 shows a cross-section of a prior art wheel substrate and polymer coating that has been ablated using a laser;
Figure 3 shows a cross-section of a polymer coating that has been partially ablated using a laser representing the invention of the present application;
Figure 4 shows an alternative embodiment of a cross-section of a polymer coating that has been partially ablated using a laser;
Figure 5 shows a further alternative embodiment of a cross-section of a polymer coating that has been partially ablated using a laser;
Figure 6 shows a still further alternative embodiment of a cross-section of a polymer coating that has been partially ablated using a laser;
Figure 7 shows a still further alternative embodiment of a cross-section of a polymer coating that has been partially ablated using a laser;
Figure 8 shows a still further alternative embodiment of a cross-section of a polymer coating that has been partially ablated using a laser;
Figure 9 shows a further alternative embodiment of a cross-section of a PVD metal layer that has been partially ablated using a laser for exposing an underlying polymer coating;
Figure 10 shows a still further alternative embodiment of a cross-section of a PVD metal layer that has been partially ablated using a laser for exposing an underlying clear polymer coating
Figures 11 shows an image of a vehicle wheel having been painted using the method of the present invention.

### DETAILED DESCRIPTION

Referring to Figure 3, a first embodiment of the present invention is generally shown at 10. A vehicle wheel 12 is formed of an alloy including, but not limited to and aluminum alloy, magnesium alloy, or a titanium alloy in a conventional manner. After forming, a surface 14 of the wheel 12 substrate his treated and cleaned in a conventional manner after which a polymer primer coat 16 is applied including a primer color. In some instances, a first polymeric coating 18 including a first color is applied over the polymer primer coat 16. The primer coat 16 includes a thickness of 3-8 mils and the first polymeric coating includes a thickness of 1-3 mils. In a known manner, the primer coat 16 is cured in a bake over prior to application of the first polymeric coating 18. In some instances, the first polymeric coating 18 is excluded and the primer color of the primer coat 16 is achieved through pigmentation to present a desired color. Otherwise, the first polymeric coating 18 is pigmented to present the first color, the purpose of which will be explained herein below.

A clear polymeric coating 20 is applied over the cured first polymeric coating 18 after the first polymeric coating 18 has been cured in a known manner. In one embodiment, the first clear polymeric coating 20 is applied as an acrylic powder having a thickness of between 3-6 mils. However, alternative clear polymeric coatings including urethanes and the like may also be used. Once the first clear polymeric coating 20 is applied, conventional curing in a bake oven is performed.

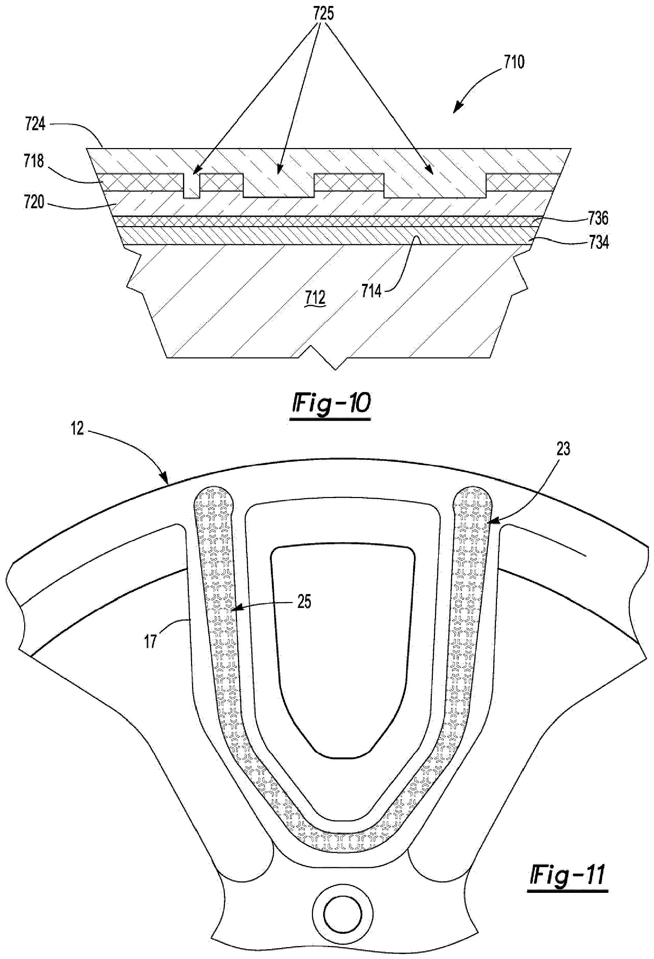

In this embodiment, after application of the first clear polymeric coating 20, a second polymeric coating 22 is applied over the first clear polymeric coating 20 including a thickness of up to 3-5 mils after curing in a conventional manner withing a bake oven. The second polymeric coating is pigmented to provide a second color that is distinguishable from the first color of the first polymeric coating 18 and the primer color of the primer coat 16. After the second polymeric coating has been cured, the wheel 12 is placed into a laser ablation station where the wheel is subjected to laser ablation. The laser is of sufficient power to evaporate polymer coatings upon exposure. The laser energy is coordinated with time of exposure to evaporate, and thereby remove, a desired amount of polymer coating. In this embodiment, a controller signals the laser a predetermined pattern directing the laser where to scan the wheel. Thus, the laser ablates a predetermined surface area of the second polymeric coating 22 and a portion of the thickness of the first clear polymeric coating 20. As used herein, the term "scan" or "scanning" represents the process of the laser beam of light scanning over the wheel 12 in the shape of a predetermined pattern 15. Therefore, the face of 23 (see also Figure 11) the wheel 12 now presents the first color of the first clear polymeric coating 20 where ablation has removed the second polymeric coating 22 and the second color of the second polymeric coating 22 is visible where the second polymeric coating 22 has not been removed. The scanning pattern of the laser is programmable to provide unique patterns 15 to the face 23 of the wheel 12 having both the first color and the second color visible. In this embodiment, the laser only removes a portion of the clear polymeric coating 20 thickness so that the first clear polymeric coating 20 still covers the visible portion of the first polymeric coating 18.

After laser ablation, a second clear polymeric coating 24 is applied over the second polymeric coating 22 and that portion of the first clear polymeric coating 20 that has been exposed through laser ablation. In one embodiment, the second to clear polymeric coating 24 includes a thickness of 3-6 mils. Through laser ablation, a two color appearance is presented through the exposure of the first clear polymeric coating 20 where the laser has scanned rendering the first polymer coating 18 visible through the first clear polymeric coating 20. By programming the laser to scan predetermined patterns, virtually any shape of ornamentation may be formed on the wheel 12, and more particularly a face of the wheel 12 as is represented in Figure 11.

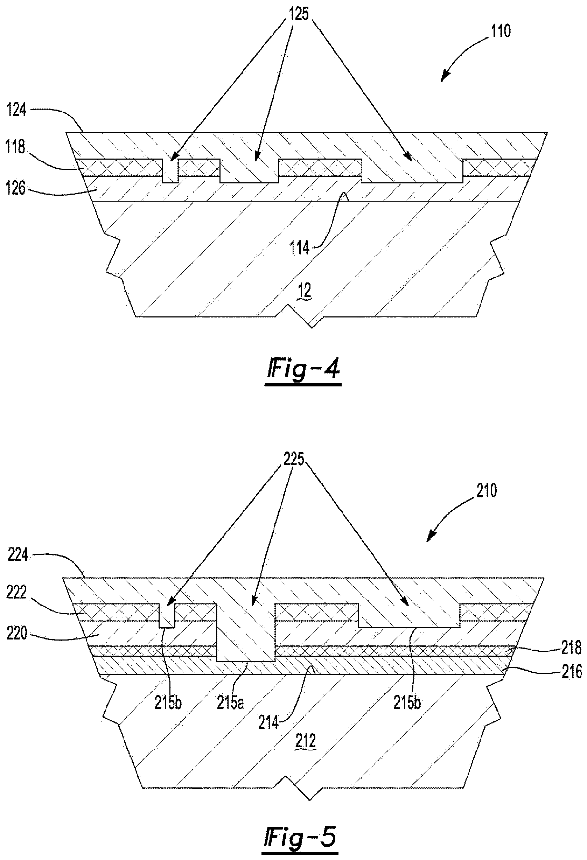

Referring now to Figure 4, an alternative embodiment is generally shown at 110 where in like elements to the first embodiment include same element numbers, but in the 100 series. For brevity these like elements will not be described again in detail. In this embodiment, a translucent clear polymeric coating 126 is applied directly to the vehicle wheel surface 114 having a film thickness equivalent to the between about 4-8 mils or alternatively between 1 and 3 mils. In one embodiment, the vehicle wheel surface 114 is milled providing a smooth shiny surface. In an alternative embodiment, the vehicle wheel surface 114 is left in an "as cast" disposition. The translucent clear polymeric coating 126 is lightly pigmented or tinted to provide a predetermined hue slightly colorizing the vehicle wheel surface 114 while allowing the wheel surface 114 to be visible. After curing the translucent clear polymeric coating 126, a first polymeric coating 118 is applied over the translucent clear polymeric coating 126 and subsequently cured in a bake oven in a known manner.

After the first polymeric coating 118 has been cured, laser ablation step is performed scanning the laser over a predetermined pattern 115 locally vaporizing the first polymeric coating 118 and partially vaporizing the translucent clear polymeric coating 126. Even though the translucent clear polymeric coating 126 is exposed to laser ablation along predetermined laser scanning pattern, a portion of the translucent clear polymeric coating 126 remains covering the wheel surface 114 giving an appearance of a tinted wheel surface 114. After the vehicle wheel 112 has been washed to remove residue associated with the laser ablation, a second clear polymeric coating 124 is applied over the first polymeric coating 118. In this embodiment, the laser scanned pattern 115 provides contrast between the tinted wheel surface 114 and the first polymeric coating 118.

A further embodiment is shown generally at 210 of Figure 5 wherein like elements of the first embodiment include the same element number but in the 200 series. For brevity, these like elements will not be described again in detail. In this embodiment, a primer coat 216 is applied to the wheel surface 214. It is anticipated that the primer coat 216 will receive ultraviolet light irradiation due to exposure to sunlight. Therefore, the primer coat 216 includes UV absorbers to protect the polymers from UV degradation.

After the primer coat 216 has been cured, a first polymeric coating 218 is applied and then subsequently cured. A first clear polymeric coating 220 is applied over the first polymeric coating 218 and again cured in a normal manner. A second polymeric coating 222 is subsequently applied over the first clear polymeric coating 220. After curing the first clear polymeric coating 220, the wheel 210 is subject to laser ablation in a pattern 215 that achieves three different colorations. Thus, a first pattern is traced by the laser and ablation is performed to two different depths, a first depth through the second polymeric coating 222, the first clear polymeric coating 220 and through the first polymeric coating 218 to expose the primer coat 216, and a second depth through the second polymeric coating 222, and partially through the first clear polymeric coating 220. Therefore, only the primer coat 216 is visible along the first pattern 215a and the first polymeric coating 218 is visible along the second pattern 215b. After the wheel 212 has been cleaned, a second clear polymeric coating 224 is applied to the wheel in a known manner.

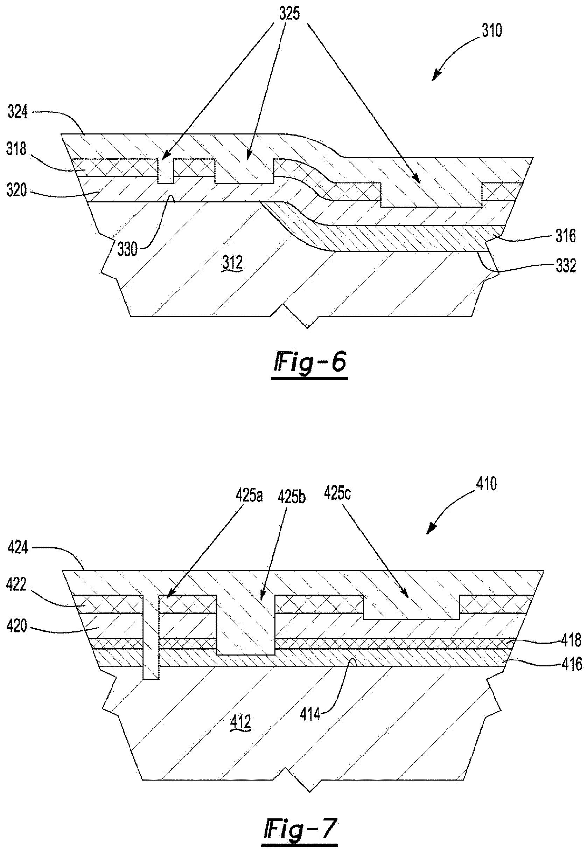

A fourth embodiment of the present invention it is generally shown at 310 in Figure 6 wherein like elements of the first embodiment include the same element number but in the 300 series. For brevity, these like elements will not be described again in detail. In this embodiment, the wheel 312 defines and upper surface 330 and a lower surface 332. The lower surface 332 may be disposed in an as-cast form, while the upper surface 330 may be milled to provide a smooth shiny surface. Furthermore, a first primer coat 216 may be applied to the wheel 312 prior to milling the upper surface 330. Therefore, exposed alloy substrate is found on the upper surface 330 that has been milled while the lower surface 332 is covered with the first primer coat 216. Following cleaning, at first clear polymeric coating 220 is applied to the wheel covering both the upper surface 330 and a lower surface 332. In this embodiment, the first clear polymeric coating 320 includes enough pigmentation to be translucent while providing a hue to both the upper surface 330 and the lower surface 332.

After the first clear polymeric coating 320 has been cured, a first polymeric coating 318 is applied over the first clear polymeric coating 320 in a known manner. After the first polymeric coating 318 has been cured, the wheel 312 is subject to laser ablation. In this embodiment, the laser scanned pattern removes portions of the first polymeric coating 318 exposing the first clear polymeric coating 320. If the laser scans over both the upper surface 330 and the lower surface 332 two different appearances are achieved, a first is on the tinted wheel substrate or upper surface 330 that has been milled and also of the primer coat 316 that remains on the lower surface 332, which is now also tinted by the first clear polymeric coating 320 forming a pattern 315 exposing two different appearances or colorations. Following cleaning, a second clear polymeric coating 324 is applied over the first polymeric coating 318.

A fifth embodiment of the present invention it is generally shown at 410 in Figure 7 wherein like elements of the first embodiment include the same element number but in the 400 series. For brevity, these like elements will not be described again in detail. In this embodiment, up to four different hues are made visible from the laser ablation. A primer polymeric coating 416 is applied to the surface 414 of the wheel 412. After curing, a first polymeric coating 418 is applied over the primer coat 416. After again occurring, the first clear polymeric coating 420 is applied over the first polymeric coating 418. A second polymeric coating 422 is applied over the first clear polymeric coating 420 after the first polymeric coating 418 has been cured.

To achieve an appearance yielding four different hues or colors, laser ablation is performed upon the layered coatings 416,418,420,422 along a scanned pattern having three different depths of ablation. A first ablation pattern 415a is formed through all of the layered coatings 416,418,420,422 to expose the wheel surface 414. A second ablation pattern 415b is formed through the second polymeric coating 422, the first clear polymeric coating 420 and the first polymeric coating 418 exposing the first primer coat 416. A third ablation pattern 415c is formed through the second polymeric coating 422 and a portion of the first clear polymeric coating 420 so that the first polymeric coating 418 is exposed. The fourth coloration is visible at locations of the second polymeric coating 422 that has not been ablated. After cleaning, a second clear polymeric coating 424 is applied over the second polymeric coating 422 in each of the exposed other coating layers.

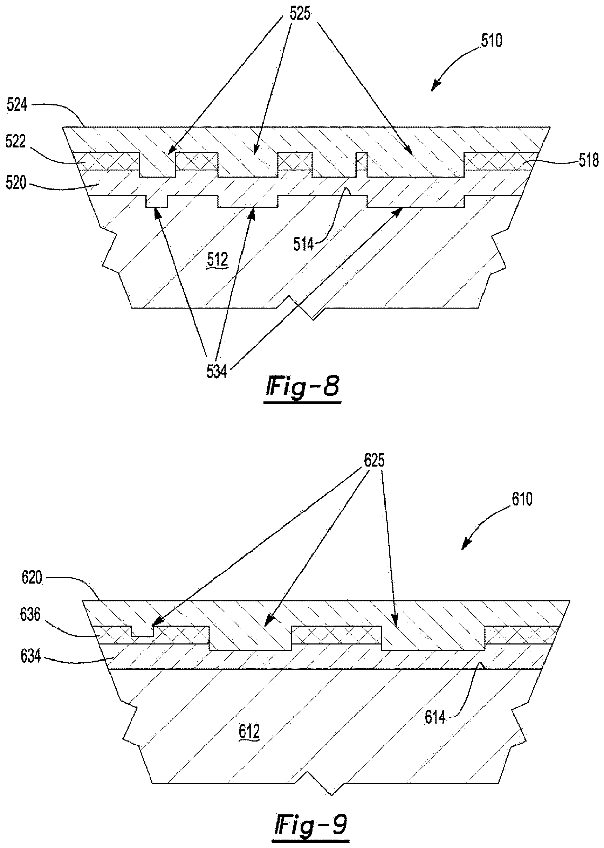

A sixth embodiment of the present invention it is generally shown at 510 in Figure 8 wherein like elements of the first embodiment include the same element number but in the 500 series. For brevity, these like elements again will not be described again in detail. In this embodiment, decorative features 534 are applied to the wheel surface 514. These features 534 include, but are not limited to, PAD printing, laser etching, application of decals and application, and any other decorative process capable of withstanding environmental riggers of a vehicle wheel. After the features have been applied to the wheel surface 514, a first clear polymeric coating 520 is applied over the wheel surface 514 and features 534, and subsequently cured. The first polymeric coating 518 is applied over the first clear polymeric coating 520 and also cured.

After the first polymeric coating 518 is cured, laser ablation is performed by scanning the laser along a pattern 515 intended to expose the decorative features 534. As such, the laser ablates through the first polymeric coating 518 and partially through the first clear polymeric coating 520 so that the decorative features 534 are now visible through the first clear polymeric coating 520. Additional ablation may be performed over the wheel surface 514 at locations that do not include a decorative feature 534 removing the first polymeric coating 518 allowing the wheel surface 514 to become visible through the first clear polymeric coating 520. After cleaning, a second clear polymeric coating 524 is applied to the wheel and subsequently cured.

A seventh embodiment of the present invention it is generally shown at 610 in Figure 9 wherein like elements of the first embodiment include the same element number but in the 600 series. For brevity, these like elements again will not be described again in detail. In this embodiment, plasma vapor deposition ("PVD") of PVD metal 636 is introduced to achieve a metallic appearance of the vehicle wheel 612. More precise processing is required due to the very thin metal thickness of the deposited PVD metal 636 that is typically less than one mil.

A primer coat 634 formulated to receive and adhere to a PVD metal is applied to the wheel surface 614 and cured in a known manner. The primer coat 634 includes pigmentation to achieve desired colorized appearance and UV absorbers to prevent degradation of the polymers from exposure to UV light. The PVD metal 636 is applied over the primer coat 634 in a conventional manner. After application, the laser ablation process is performed scanning the laser over a pattern 615 to remove portions of the PVD metal 636 exposing the primer coat 634 in the shape of the laser scanned pattern. After cleaning, a first clear polymeric coating 620 is applied over the PVD metal 636 and that portion of the PVD primer 634 exposed via laser ablation. Therefore, the wheel has an overall metallic appearance with a colorized pattern 615 established via exposure of the primer coat 634 via laser ablation.

An eighth embodiment of the present invention it is generally shown at 710 in Figure 10 wherein like elements of the first embodiment include the same element number but in the 700 series. For brevity, these like elements again will not be described again in detail. A primer coat 734 is applied to the wheel surface 714. The primer coat 734 is formulated to receive and adhere to a PVD metal 736 is applied directly to the wheel surface 714 and cured in a known manner. The PVD metal 736 is applied over the primer coat 734 in a conventional manner. A first clear polymeric coating 720 is applied to the PVD metal 736 and cured in a known manner followed by application of a first polymeric coating 718 over the first clear polymeric coating 720.

After application of the first polymeric coating 718, the laser ablation process is performed scanning the laser in a pattern 715 to remove portions of the first polymeric coating 718 exposing the first clear polymeric coating 720 making the PVD metal layer 736 visible through the first clear polymeric coating 720. In this embodiment, the pattern 715 formed by laser ablation presents a metallic appearance while that portion of the first polymeric coating 718 not removed via laser ablation presents a contrasting appearance to the PVD metal pattern presented by the PVD metal layer 736. Following ablation, the wheel 712 is cleaned and a second clear polymeric coating 724 is applied over the first polymeric coating 718.

Referring again to Figure 11, the result of the laser ablation of the present invention represented on the wheel 12. The pattern 15 is ablated on the face 23 of the wheel 12, in this embodiment, a spoke 17. The pattern 15 presents a contrast to the second polymeric coating 22 providing an unique aesthetic to the wheel 12 appearance not previously available to production vehicle wheels 12.

The invention has been described is in an illustrative manner; many modifications and variations of the present invention are possible, including removal of toxins from fluids, in light of the above teachings. It is therefore to be understood that within the specification, the reference numerals are merely for convenience, and are not to be in any way limiting, and that the invention may be practiced otherwise than is specifically described. Therefore, the invention can be practiced otherwise than is specifically described within the scope of the stated claims following this first disclosed embodiment.

## Claims

1. A method of manufacturing a vehicle wheel, comprising the steps of:
providing a wheel including an alloy substrate;
applying a first polymeric coating to a surface of said alloy substrate with said first polymeric coating defining a first coloration;
applying an intermediate clear polymeric coating over said first polymeric coating;
applying a second polymeric coating over said first polymeric coating with said second polymeric coating defining a second coloration being distinguishable from said first coloration; and
using a laser for scanning a pattern over said second polymeric coating thereby ablating said second polymeric coating rendering said first polymeric coating visible through said intermediate clear polymeric coating for defining a pattern of exposed first polymeric coating.

2. The method set forth in claim 1, further comprising a step of apply an outer clear polymeric coating over said second polymeric coating after scanning the pattern over said polymeric second polymeric coating with said laser.

3. The method set forth in claim 2, further including a step of cleaning said vehicle wheel after said laser ablates said second polymeric coating.

4. The method set forth in claim 1, wherein said step of using said laser for scanning a pattern over said second polymeric coating is further defined by ablating a portion of said intermediate clear polymeric coating thereby reducing a film thickness of said intermediate clear polymeric coating.

5. The method set forth in claim 2, further including a step of applying a second intermediate clear polymeric coating over said second polymeric coating and applying a third polymeric coating defining a third coloration over said second intermediate polymeric coating.

6. The method set forth in claim 5, further including a step of scanning a second pattern with said laser for ablating the third polymeric coating thereby rendering the second polymeric coating visible defining the second coloration defining a second pattern of said second polymeric coating.

7. The method set forth in claim 6, wherein said step of scanning a second pattern with said laser for ablating said third polymeric coating is further defined by ablating a portion of said intermediate clear polymeric coating thereby reducing a film thickness of said intermediate clear polymeric coating whereat ablation occurs.

8. The method set forth in claim 7, wherein said steps of ablating said second polymeric coating and said third polymeric coating render said first polymeric coating and said second polymeric coating visible through said third polymeric coating via said first pattern and said second pattern respectively.

9. The method set forth in claim 8, further including a step of apply an outer clear polymeric coating over said third polymeric coating after scanning said first pattern and said second pattern over said polymeric second polymeric coating with said laser.

10. The method set forth in claim 4, wherein said step of reducing the film thickness of said intermediate clear polymeric coating is further defined by controlling an amount of film thickness being ablated by one of laser speed and laser power.

11. The method set forth in claim 1, further including a step of applying a physical vapor deposition (PVD) metal over one of said first polymeric coating or said second polymeric coating and rendering said PVD metal visible by ablating a pattern of said second polymeric coating or ablating a pattern of PVD metal rendering said polymeric coating disposed beneath said PVD metal visible.

12. A vehicle wheel, comprising:
an alloy substrate defining a surface;
a first polymeric coating defining a first coloration applied to said surface;
an intermediate clear polymeric coating applied over said first polymeric coating;
a second polymeric coating applied defining a second coloration applied over said intermediate clear polymeric coating; and
a pattern defined by said second polymeric coating exposing said intermediate clear polymeric coating rendering said first polymeric coating visible through said intermediate clear polymeric coating thereby presenting a two-tone appearance between said first coloration and said second coloration.

13. The wheel set forth in claim 12, wherein said intermediate clear polymeric coating defines a first film thickness being lower than a second film thickness at said pattern defined by said second polymeric coating.

14. The wheel set forth in claim 12, wherein said second polymeric coating is substantially covered by an outer clear polymeric coating.

15. The wheel set forth in claim 12, wherein said pattern is defined by laser ablation of said second polymeric coating.

16. The wheel set forth in claim 12, wherein a physical vapor deposition (PVD) metal is disposed between said first polymeric coating and said intermediate polymeric coating and said PVD metal is visible at through said pattern defined by said second polymeric coating.

17. The wheel set forth in claim 12, wherein a physical vapor deposition (PVD) metal is disposed beneath said outer clear polymeric coating and defines a pattern rendering said first polymeric coating visible through said pattern.

18. The wheel set forth in claim 12, wherein said pattern is defined by both said second polymeric coating and said first polymeric coating thereby rendering said surface of said wheel visible at said pattern.

19. The wheel set forth in claim 18, wherein said surface of said wheel rendered visible at said pattern is milled.

20. The wheel set forth in claim 12, wherein a second intermediate clear polymeric coating is applied over said second polymeric coating and a third polymeric coating defining a third coloration is applied over said second intermediate coating.

21. The wheel set forth in claim 20, wherein said third polymeric coating defines a pattern rendering said second polymeric coating visible through said second intermediate clear polymeric coating thereby presenting a plurality of patterns having an appearance between said first coloration, said second coloration and said third coloration.
